# EUROPEAN PATENT APPLICATION

(11) **EP 4 636 822 A1**
(43) Date of publication of application: **22.10.2025**
(21) Application number: 25168311.6
(22) Date of filing: 03.04.2025
(51) Int. Cl.: H01L 23/373, C04B 37/02

(54) **A HEAT DISSIPATION SUBSTRATE FOR A POWER SEMICONDUCTOR MODULE AND A CONVERTER INCLUDING THE SAME**

(30) Priority: 04.04.2024 KR 20240046173; 04.12.2024 KR 20240178958
(71) Applicant: LX Semicon Co., Ltd., Daejeon 34027 (KR)
(72) Inventor: CHO, Nam Tae, 34027 Daejeon (KR); LEE, Myoung Ho, 34027 Daejeon (KR); KIM, Deog Soo, 34027 Daejeon (KR)
(74) Representative: Ter Meer Steinmeister & Partner

(57) **Abstract**

A heat dissipation substrate for a power semiconductor module according to an embodiment can include an insulating substrate; a first metal plate disposed on the insulating substrate; a second metal plate disposed under the insulating substrate; and a filler disposed within the insulating substrate. The filler may be in contact with a lower surface of the first metal plate.

## Description

### BACKGROUND

### Field of the Disclosure

The embodiment relates to a ceramic substrate for a heat dissipation substrate, a heat dissipation substrate for a power semiconductor module, a power semiconductor module including the same, a power conversion device including the same, and a manufacturing method thereof.

### Description of the Background

A power conversion module is a device that performs power conversion (AC->DC, DC->AC), power transformation (step-down, step-up), power distribution, or power control functions, and is a core component that performs the function of improving energy efficiency in the process of transmitting and controlling power and controlling voltage changes to provide system stability and reliability, and is referred to as a power module or a power system.

A power conversion module includes various components such as a power semiconductor device, a heat dissipation substrate, a base plate, molding silicon, a case and cover, and a terminal.

Recently, eco-friendly cars based on electric or hydrogen are gaining attention instead of fossil fuel-based internal combustion engine cars, and these eco-friendly cars use numerous power semiconductor devices. Eco-friendly cars include hybrid electric vehicles (HEVs), plug-in hybrid electric vehicles (PHEVs), electric vehicles (EVs), and fuel cell electric vehicles (PCEVs).

In addition, power semiconductors are used in various electric and electronic devices such as electric vehicle chargers, energy storage devices, power supply devices, and railways in addition to eco-friendly cars.

Previously, silicon (Si) power semiconductor devices were widely used, but as Si power semiconductors reached their physical limits, research on WBG (Wide Bandgap) power semiconductors such as silicon carbide (SiC) or gallium nitride (GaN) to replace them is actively being conducted.

WBG power semiconductor devices have a band gap energy approximately three times higher than that of Si power semiconductor devices, a dielectric breakdown field approximately ten times higher than that of Si power semiconductor devices, and a thermal conductivity approximately three times higher than that of Si power semiconductor devices. Due to these excellent characteristics, WBG power semiconductor devices may operate in high temperature and high voltage environments and have the advantage of high switching speeds and low switching losses.

For example, Si-based power semiconductor modules used to perform power conversion (DC↔AC), motor drive switching, control, etc. in conventional electric vehicles, hybrid electric vehicles, etc. were operated in a temperature environment of about 150°C, but recently, due to the demand for increased switching performance and power density, research is actively being conducted on wide band gap (WBG)-based power semiconductor devices such as SiC or GaN that may operate at a usage temperature of about 300°C or higher, for example, at about 300~700°C.

Meanwhile, the heat generated from the power semiconductor generates thermomechanical stress in each part of the power semiconductor module, and the lifespan of the junction and power semiconductor devices may be deteriorated due to thermal fatigue at the junction. Therefore, the reliability design of the power semiconductor module that appropriately releases the heat generated from the power semiconductor device through the heat dissipation substrate and maintains the junction temperature of the power semiconductor device below an appropriate temperature is very important.

Meanwhile, the heat dissipation substrate for power semiconductors not only has the function of transferring heat generated during the operation of power semiconductor devices to the outside, but also has an important function of electrically connecting power semiconductor devices by forming a circuit pattern on one side of the heat dissipation substrate.

Conventional heat dissipation substrates for power semiconductors may be classified into the DBC (direct bonded copper) method and the AMB (active metal brazing) method according to the bonding method. The DBC method is a method of forming an oxide film on a copper (Cu) layer and then directly bonding it to ceramic. The AMB method is a method of performing brazing by interposing a paste containing relatively low melting point metal particles between the base metal and ceramic.

However, recently, high voltage/high power SiC power conversion modules of 1200 V, 200~800 A are being used for performance improvement of hybrid and electric vehicles and autonomous vehicles. During the operation of these high-performance electric vehicles, the operating temperature of the power semiconductor devices is to be implemented at an average of 150°C or higher, and the maximum operating temperature is momentarily 200°C or higher.

In such a high temperature, high voltage, and high current operating environment, the existing bonding materials themselves may be re-melted, and the life of the power semiconductor module may deteriorate rapidly due to the heat trap phenomenon caused by the pores present in the bonding part. For example, cracks may occur due to defects induced at the interface between the ceramic substrate of the heat dissipation substrate and the copper (Cu) sheet, and cracks induced in such a heat dissipation substrate may cause thermal runaway, leading to the destruction of the power semiconductor devices.

For example, if the heat dissipation performance is reduced due to cracks, etc. in the heat dissipation substrate, the power semiconductor module case and surrounding temperature may increase. At this time, if the heat generation exceeds the heat dissipation performance due to the rapid temperature increase (heat generation state > heat dissipation performance), the thermal equilibrium state (heat generation state < heat dissipation performance) according to the thermal design is not maintained and the heat generation continues to increase. As a result, the leakage current continues to increase, which ultimately leads to the destruction of the power semiconductor module itself.

In particular, in the case where the deterioration problem of the power semiconductor module occurs in an ultra-high temperature operating temperature environment, the destruction of the power semiconductor device due to malfunction of the power semiconductor module installed in the vehicle may have a serious impact on the safety of the driver.

Accordingly, it is necessary to improve the heat dissipation performance of the heat dissipation substrate that constitutes the power semiconductor module, and a heat dissipation substrate that may prevent reliability degradation due to high temperature and high pressure is required.

### SUMMARY

Accordingly, the present disclosure is directed to a heat dissipation substrate for a power semiconductor module and a convertor including the same that substantially obviates one or more of problems due to limitations and disadvantages described above.
One of the technical objects of the embodiment is to improve the heat dissipation performance of the heat dissipation substrate.

In addition, one of the technical objects of the embodiment is to prevent peeling between the metal plate and the insulating substrate and to improve reliability.

In addition, one of the technical objects of the embodiment is to disperse external stress in the heat dissipation substrate and to improve reliability.

The technical problems of the embodiment are not limited to those described in this item and include those that may be understood through the description of the invention.

A heat dissipation substrate for a power semiconductor module according to the embodiment may include an insulating substrate (210); a first metal plate (221) disposed on the insulating substrate (210), a second metal plate (222) disposed under the insulating substrate (210) and a filler (241) disposed within the insulating substrate (210). The filler (241) may be in contact with the lower surface of the first metal plate (221). In addition, in the embodiment, the filler may include a plurality of fillers and may be disposed spaced apart from each other.

In addition, in the embodiment, the filler (241) may be disposed to extend downward. In addition, the embodiment may include a bonding metal layer and a diffusion metal layer disposed between the first metal plate (221) and the insulating substrate (210), and the first metal plate (221) and the filler (241) may be in contact.

In addition, in the embodiment, the filler (241) may include a cylindrical shape. In addition, in the embodiment, the filler (241) may include a hemispherical shape. In addition, in the embodiment, a pin-fin structure (250) disposed on the lower surface of the second metal plate (222) may be further included.

The filler may be spaced apart from the upper surface of the second metal plate. The filler may include a first filler in contact with the lower surface of the first metal plate and a second filler in contact with the upper surface of the second metal plate.

A horizontal width of the plurality of second fillers may be larger than each horizontal width of the plurality of first fillers, and the first filler may not be in contact with the second metal plate. The second fillers may be alternately disposed on surfaces facing each other with the first fillers.

In addition, the embodiment may further include a pin-fin structure disposed on the lower surface of the second metal plate.

A vertical length of the first filler or the second filler may be at least 1/2 of the thickness of the insulating substrate. The first filler and the second filler may be disposed to be vertically staggered, and the horizontal width of the region where the second filler is disposed may be larger than the horizontal width of the region where the first filler is disposed.

In addition, a heat dissipation substrate for a power semiconductor module according to another embodiment may include an insulating substrate (210); a first metal plate (221) disposed on the insulating substrate (210); a second metal plate (222) disposed under the insulating substrate (210); and a filler (243) disposed in the insulating substrate (210). And the filler (241) may include a plurality of first fillers (243a) and a plurality of second fillers (243b), and the plurality of first fillers (243a) are in contact with the lower surface of the first metal plate (221), and the plurality of second fillers (243b) are in contact with the upper surface of the second metal plate (222). And the horizontal width of the plurality of second fillers (243b) is larger than the horizontal width of the plurality of first fillers (243a), and the first filler (243a) may not be in contact with the second metal plate (222).

In addition, in the embodiment, the second filler (243b) may not be in contact with the first filler (243a).

In addition, in the embodiment, the second filler (243b) may be alternately disposed on the surface facing the first filler (243a).

In the embodiment, the heat dissipation substrate for the power semiconductor module has a technical effect that the heat dissipation performance of the device can be improved by increasing the area through which heat is transferred as the filler (241) is disposed under the first metal plate (221).

For example, in the embodiment, the first metal plate (221) is disposed under the semiconductor device (230), and the filler (241) is disposed on the lower surface of the first metal plate (221), so that the area through which heat is transferred increases and the heat dissipation performance can be improved.

In addition, the embodiment has a technical effect that the heat transfer path within the insulating substrate (210) can be shortened and the heat dissipation performance can be improved.

For example, the embodiment can improve heat dissipation performance by shortening the heat transfer path because a filler with excellent thermal conductivity is disposed inside the insulating substrate (210) and heat is transferred through the filler.

In addition, the embodiment has a technical effect of preventing the metal plate (220) and the insulating substrate (210) from being separated and improving reliability.

For example, the embodiment can increase the bonding area between the ceramic of the insulating substrate (210) and the copper (Cu) of the filler (241), thereby increasing the bonding force, thereby preventing the metal plate (220) and the insulating substrate (210) from being separated, and improving reliability.

In addition, the embodiment has a technical effect that can effectively disperse external stress, thereby improving reliability.

For example, the embodiment increases the bonding area between the ceramic of the insulating substrate (210) and the copper (Cu) of the filler (241), thereby increasing the bonding force, thereby preventing the metal plate (220) and the insulating substrate (210) from being separated, and improving reliability.

In addition, the embodiment has a technical effect of uniformly filling the via formed in the insulating substrate (210) by repeatedly filling and heat-treating copper in the via of the insulating substrate (210) to form a filler, thereby suppressing the occurrence of voids and improving heat dissipation performance.

In addition, the embodiment has a technical effect of evenly distributing heat.

For example, the embodiment can evenly distribute heat by forming the horizontal width of the third-second filler (243b) larger than the horizontal width of the third-first filler

(243a) as the heat transferred from the semiconductor device (230) increases in the horizontal direction as it is transferred downward.

The technical effect of the embodiment is not limited to what is described in this item and includes what may be understood through the description of the invention.

### BRIEF DESCRIPTION OF THE DRAWINGS

Fig. 1 is a cross-sectional view of a power semiconductor module (500) including a heat dissipation substrate for power semiconductors according to an embodiment.
Fig. 2 is a manufacturing process drawing of a power semiconductor module (501) including a heat dissipation substrate for power semiconductors according to an embodiment.
Fig. 3 is a process flow chart of a manufacturing process of a heat dissipation substrate for power semiconductors according to an embodiment.
Fig. 4 is a cross-sectional view of a power semiconductor module including a heat dissipation substrate for power semiconductors according to the first embodiment.
Fig. 5 is a cross-sectional view of a power semiconductor module including a heat dissipation substrate for power semiconductors according to the second embodiment.
Fig. 6A is a cross-sectional view of a power semiconductor module including a heat dissipation substrate for power semiconductors according to the third embodiment.
Fig. 6B is a cross-sectional view of a power semiconductor module including a heat dissipation substrate for power semiconductors according to an additional embodiment of the third embodiment.
Fig. 7 is a cross-sectional view of a power semiconductor module including a heat dissipation substrate for power semiconductors according to the fourth embodiment.

### DETAILED DESCRIPTION

Hereinafter, the invention according to an embodiment for solving the above problem will be described in more detail with reference to the drawings.

The suffixes "module" and "part" used for components in the following description are given simply for the convenience of writing this specification, and do not themselves give a particularly important meaning or role. Therefore, the "module" and "part" may be used interchangeably.

Terms including ordinal numbers such as first, second, etc. may be used to describe various components, but the components are not limited by the terms. The terms are used only for the purpose of distinguishing one component from another component.

The singular expression includes the plural expression unless the context clearly indicates otherwise.

In the present application, the terms "includes," or "has" are intended to specify the presence of a feature, number, step, operation, component, part, or combination thereof described in the specification, and should be understood as not excluding in advance the possibility of the presence or addition of one or more other features, numbers, steps, operations, components, parts, or combinations thereof.

In the embodiment, the power semiconductor module may be used in inverters or converters of automobiles, computers, home appliances, solar power, smart grids, etc. In addition, the power semiconductor module according to the embodiment may be applied to various electric and electronic devices such as electric vehicle chargers, power supply devices, or railways in addition to eco-friendly automobiles.

In addition, the heat dissipation substrate for power semiconductors according to the embodiment may be mounted and used in power semiconductor modules employed in inverters or converters of automobiles, computers, home appliances, solar power, smart grids, etc. In addition, the heat dissipation substrate for power semiconductors according to the embodiment may be mounted and used in power semiconductor modules mounted in various electric and electronic devices such as electric vehicle chargers, power supply devices, or railways in addition to eco-friendly automobiles.

In the embodiment, the power semiconductor device may include one power semiconductor module or multiple power semiconductor modules. In addition, the power semiconductor module may include multiple power semiconductor devices.

In the embodiment below, the power semiconductor device describes an inverter for driving a motor for an automobile, but the power semiconductor device of the embodiment may be applied to inverters or converters in various technical fields described above. Here, the automobile includes a hybrid vehicle (HEV), a plug-in hybrid vehicle (PHEV), an electric vehicle (EV), a fuel cell vehicle (PCEV), etc. In the description of the embodiment below, the switching element and the power semiconductor device may be used interchangeably.

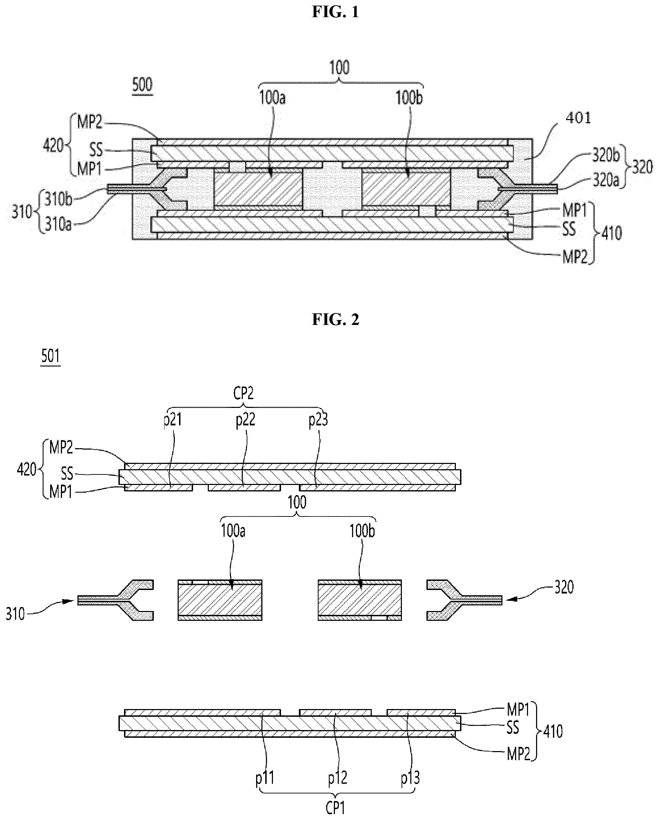

FIG. 1 is a cross-sectional view of a power semiconductor module (500) including a heat dissipation substrate for a power semiconductor according to an embodiment, and FIG. 2 is a manufacturing process drawing of a power semiconductor module (501) including a heat dissipation substrate for a power semiconductor according to an embodiment.

Referring to FIG. 1, a power semiconductor module (500) according to an embodiment may include a first heat dissipation substrate (410), a second heat dissipation substrate (420), a power semiconductor device (100), a first lead frame (310), and a second lead frame (320), and may be packaged by a mold (401). The mold (401) may include an EMC (Epoxy Molding Compound), but is not limited thereto. The power semiconductor device (100) may include a first power semiconductor device (100a) and a second power semiconductor device (100b).

For example, referring to FIG. 2, a first lead frame (310), a second lead frame (320), and single or multiple power semiconductor devices (100a, 100b) are disposed between a first heat dissipation substrate (410) and a second heat dissipation substrate (420), and then pressed to manufacture a power semiconductor module (501) according to an embodiment.

The power semiconductor device (100) and the first heat dissipation substrate (410) and the second heat dissipation substrate (420) may be bonded through a predetermined adhesive member (not shown).

For example, the first and second heat dissipation substrates (410, 420) may be bonded to the power semiconductor device (100) through soldering, sintering bonding, transient liquid phase bonding (TLP bonding), ultrasonic bonding, etc.

In the power semiconductor module (500) according to the embodiment, the first power semiconductor device (100a) and the second power semiconductor device (100b) may form one arm. For example, the first power semiconductor device (100a) and the second power semiconductor device (100b) may be connected in series with the electrodes disposed in opposite directions, but the invention is not limited thereto. For example, the first power semiconductor device (100a) and the second power semiconductor device (100b) may be electrically connected in parallel.

In the embodiment, the first and second heat dissipation substrates (410, 420) may be disposed on the lower and upper sides of the power semiconductor module (500), respectively, but the invention is not limited thereto.

The first heat dissipation substrate (410) may include a first metal plate (MP1), an insulating substrate (SS), and a second metal plate (MP2).

The insulating substrate (SS) may electrically insulate the first metal plate (MP1) and the second metal plate (MP2). The insulating substrate (SS) may include a polycrystalline insulating substrate made of a ceramic material with high thermal conductivity. For example, the insulating substrate (SS) may be one of AlN or Si₃N₄, but is not limited thereto, and may also be Al₂O₃, etc. In addition, the insulating substrate (SS) may include a single-crystal substrate such as a sapphire substrate.

Hereinafter, the insulating substrate (SS) may be described as a polycrystalline substrate made of a ceramic material, but is not limited thereto, and may also include a single-crystal substrate.

The first metal plate (MP1) and the second metal plate (MP2) may include a Cu-series metal, but is not limited thereto.

The second metal plate (MP2) may have one side in contact with the insulating substrate (SS) and dissipate heat to the other side. On the other side of the second metal plate (MP2), a heat dissipation means including a cooling medium may be disposed in close proximity.

Referring to FIG. 2, the first metal plate (MP1) disposed on the lower side of the power semiconductor device (100) may include a first circuit pattern (CP1) formed by a patterning process such as etching, and the first circuit pattern (CP1) may be electrically connected to the electrodes of the power semiconductor device (100).

For example, the first circuit pattern (CP1) may include a first-first circuit pattern (p11), a first-second circuit pattern (p12), and a first-third circuit pattern (p13) that are electrically separated, and may be electrically connected to the first power semiconductor device (100a) and the second power semiconductor device (100b), as shown in FIG. 1, respectively.

In addition, the second heat dissipation substrate (420) may also include a first metal plate (MP1), an insulating substrate (SS), and a second metal plate (MP2). The second heat dissipation substrate (420) may adopt the technical features of the first heat dissipation substrate (410).

Referring to FIG. 1, one side of each of the first lead frame (310) and the second lead frame (320) may be electrically connected to the power semiconductor device (100), and the other side of each may be connected to an external connection terminal. The external connection terminal may include an input power source, a motor, or an inverter controller.

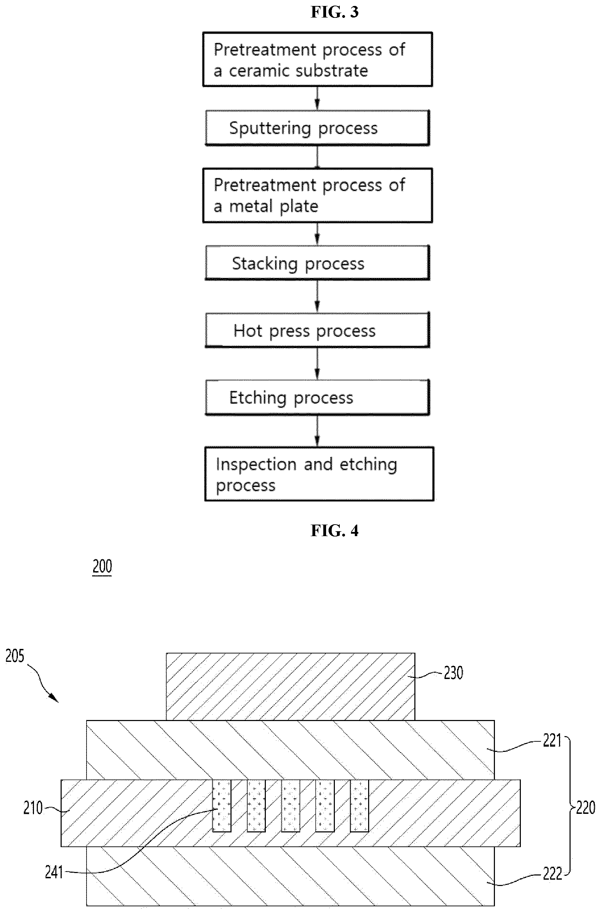

Next, FIG. 3 is a schematic process flow diagram of a process for manufacturing a heat dissipation substrate for a power semiconductor according to an embodiment.

The process for manufacturing a heat dissipation substrate for a power semiconductor according to an embodiment may include following process.
① a pretreatment process of the insulating substrate, ② a sputtering process, ③ a pretreatment process of the metal plate, ④ a lamination process of the insulating substrate and the metal plate, ⑤ a hot press process of the insulating substrate and the metal plate, ⑥ an etching process of the heat dissipation substrate, ⑦ an inspection and cutting process of the heat dissipation substrate, etc.

The entire manufacturing process of the heat dissipation substrate for power semiconductors according to the embodiment may be controlled by a control unit (not shown) of a central server, and the central server may include a data storage unit (not shown).

The insulating substrate for manufacturing the heat dissipation substrate according to the embodiment below may be described as an example of a polycrystalline ceramic substrate, but is not limited thereto, and may include a single-crystal substrate such as a sapphire substrate.

FIG. 4 is a conceptual diagram of a power semiconductor module (200) having a heat dissipation substrate (205) for a power semiconductor module according to the embodiment. Referring to FIG. 4, a power semiconductor module (200) may include a heat dissipation substrate (205) and a semiconductor device (230) disposed on the heat dissipation substrate (205).

The heat dissipation substrate (205) may include an insulating substrate (210), a metal plate (220), and a first filler (241). The insulating substrate (210) may include ceramic. For example, the insulating substrate (210) may include one of Al₂O₃, Si₃N₄, and AIN, but is not limited thereto. In addition, the insulating substrate (210) may include a glass substrate.

In addition, the metal plate (220) may include a first metal plate (221) disposed on the insulating substrate (210) and a second metal plate (222) disposed under the insulating substrate

(210). The metal plate (220) may include a Cu-based metal, but is not limited thereto. In addition, the thickness of the insulating substrate (210) may be greater than the thickness of the metal plate (220), but is not limited thereto.

Meanwhile, in the embodiment, the first filler (241) may be disposed within the insulating substrate (210). The first filler (241) may be formed by filling the via after a via is formed within the insulating substrate (210). In addition, the first filler (241) may include a metal having excellent thermal conductivity. For example, the first filler (241) may include a Cu-based metal, but is not limited thereto.

In addition, the first filler (241) may be disposed at a position that vertically overlaps the semiconductor device (230). In addition, the first filler (241) may be in contact with the lower surface of the first metal plate (221). Therefore, the embodiment has a technical effect that the area through which heat is transferred increases as the first filler (241) is disposed under the first metal plate (221), thereby improving the heat dissipation performance of the device. In addition, the embodiment has a technical effect that the heat transfer path within the insulating substrate (210) can be shortened, thereby improving the heat dissipation performance.

In addition, the embodiment has a technical effect that the bonding area between the ceramic of the insulating substrate (210) and the copper (Cu) of the first filler (241) increases, thereby increasing the bonding force, thereby preventing the metal plate (220) and the insulating substrate (210) from being separated, and improving reliability.

The first filler (241) may have a cylindrical shape, but is not limited thereto. In addition, the first filler (241) may not be in contact with the second metal plate (222). The lower surface of the first filler (241) may be spaced apart from the upper surface of the second metal plate

(222). Accordingly, the first metal plate (221) and the second metal plate (222) may be electrically insulated.

In addition, the first filler (241) may be disposed to extend downward along the vertical direction from the lower surface of the first metal plate (221). Accordingly, the embodiment has a technical effect that the reliability can be improved because the first filler (241) may exist vertically within the insulating substrate (210), thereby effectively dispersing external stress compared to the bonding surface of the metal plate where the bonding surface exists only in the horizontal direction.

Briefly, a method for manufacturing a heat dissipation substrate for power semiconductors according to the embodiment will be described.
First, a via may be formed in the insulating substrate (210), and then Cu may be filled in the via to form the first filler (241). In detail, the via may be formed by laser, etching, etc. After the via is formed, surrounding by-products may be removed through surface polishing or chemical cleaning. Next, Cu may be filled in the via. Copper may be Cu paste or Cu rod, but is not limited thereto. In addition, the copper filled in the via may be heat treated to uniformly fill the inside of the via. In addition, the embodiment may repeat copper filling and heat treatment in the via. Accordingly, the embodiment has a technical effect of uniformly filling the via formed in the insulating substrate (210), preventing shrinkage of copper to suppress void generation, and improving heat dissipation performance.

Thereafter, a bonding metal layer (not shown) and a diffusion metal layer (not shown) may be deposited on the insulating substrate (210). The above bonding metal layer may include Ti, but is not limited thereto. In addition, the diffusion metal layer may include Al, but is not limited thereto. In addition, a heat dissipation substrate may be manufactured by placing a metal plate (220) on the insulating substrate (210) and then thermally compressing the metal plate. At this time, the bonding metal layer (not shown) and the diffusion metal layer (not shown) are thin, and the first filler (241) of the insulating substrate (210) may be bonded to be in contact with the metal plate (220) according to a high-pressure bonding process. Therefore, the embodiment has a technical effect in that Cu-Cu bonding is formed, thereby strengthening the bonding strength between the insulating substrate (210) and the metal plate (220), thereby improving reliability.

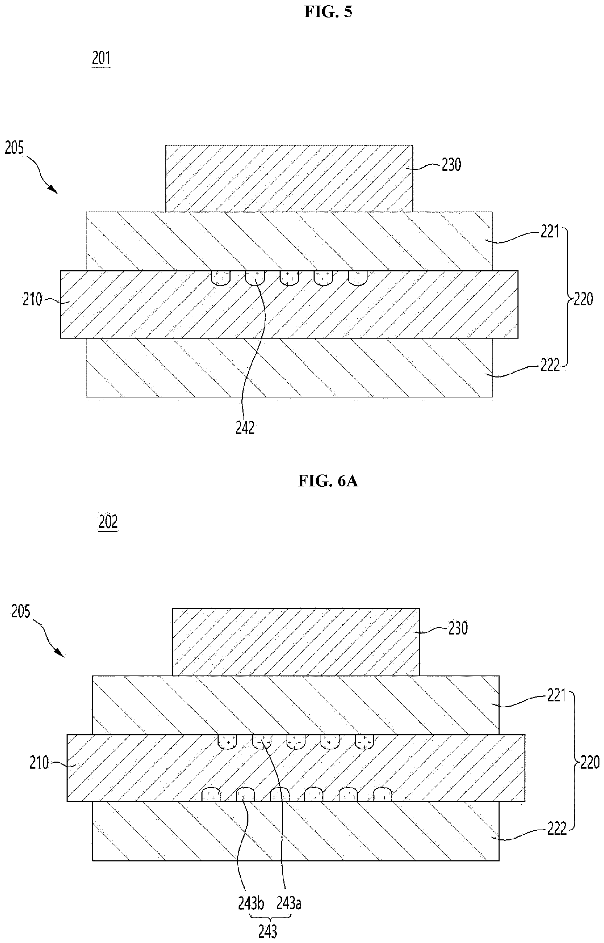

FIG. 5 is a conceptual diagram of a power semiconductor module (201) having a heat dissipation substrate (205) for a power semiconductor module according to the second embodiment. The second embodiment may adopt the technical features and manufacturing method of the first embodiment. Referring to FIG. 5, a second filler (242) may be disposed within an insulating substrate (210). The second filler (242) may have a convex shape downward. The second filler (242) may have a hemispherical shape, but is not limited thereto. The upper surface of the second filler (242) may contact the lower surface of the first metal plate (221). In addition, the second filler (242) may include a plurality of pieces. The plurality of second fillers (242) may be disposed at a predetermined interval from each other.

In addition, the second filler (242) may be disposed so as to vertically overlap the semiconductor device (230). In addition, the second filler (242) may not be in contact with the second metal plate (222).

Therefore, the second embodiment has a technical effect that the area of the heat dissipation plate increases as the second filler (242) is disposed on the lower surface of the first metal plate (221), thereby improving the heat dissipation performance. In addition, the second embodiment has a technical effect that the bonding area between the insulating substrate (210) and the second filler (242) increases, thereby increasing the bonding force between the first metal plate (221) and the insulating substrate (210), thereby preventing peeling.

Fig. 6A is a conceptual diagram of a power semiconductor module (202) having a heat dissipation substrate (205) for a power semiconductor module according to the third embodiment. The third embodiment may adopt the technical features and manufacturing methods of the first embodiment and the second embodiment.

Referring to Fig. 6A, the third filler (243) may be disposed in the insulating substrate (210). The third filler (243) may include a third-first filler (243a) and a third-second filler (243b). The third-first filler (243a) may be disposed on the lower surface of the first metal plate (221). In addition, the third-second filler (243b) may be disposed on the upper surface of the second metal plate (222). The third-first filler (243a) may have a shape that is convex downward, and the third-second filler (243b) may have a shape that is convex upward.

In addition, the third-first filler (243a) and the third-second filler (243b) may include a plurality of pieces that are disposed spaced apart from each other. The third-second filler (243b) may vertically overlap the spaced apart spaces of each of the plurality of third-first fillers (243a). The third-second filler (243b) may be alternately disposed on the surface facing the third-first filler (243a). In addition, the third-second filler (243b) may not vertically overlap the third-first filler (243a). In addition, the third-second filler (243b) may vertically overlap the third-first filler (243a).

In addition, the third-first filler (243a) and the third-second filler (243b) may not contact each other. In addition, the third-first filler (243a) may not contact the second metal plate (222).

Accordingly, the third embodiment has a technical effect that the third filler (243) is disposed in the insulating substrate (210) so that heat is transferred through the third filler (243), thereby improving the heat dissipation performance. In addition, the third embodiment has a technical effect that the insulating substrate (210), the third filler (243), and the metal plate (220) increase the bonding force as they are joined to each other, thereby preventing peeling and improving reliability.

Meanwhile, the horizontal width of the area where the third-second filler (243b) is disposed may be larger than the horizontal width of the area where the third-first filler (243a) is disposed. In addition, the number of the third-second fillers (243b) may be greater than the number of the third-first fillers (243a). Accordingly, the third embodiment has a technical effect of evenly distributing heat by forming the horizontal width of the third-second filler (243b) larger than the horizontal width of the third-first filler (243a) as the heat transferred from the semiconductor device (230) increases in the horizontal direction as it is transferred downward.

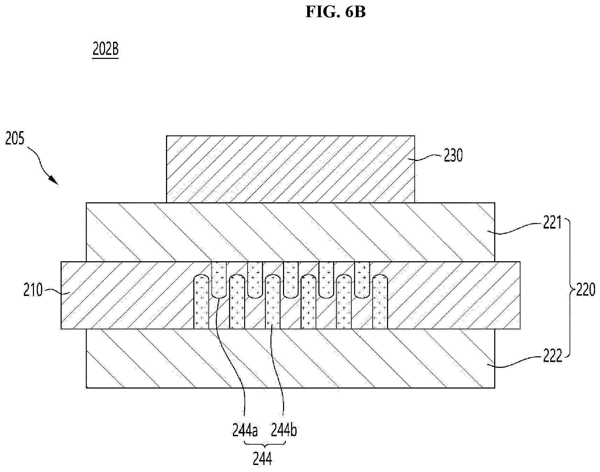

Next, FIG. 6B shows a cross-sectional view of a power semiconductor module (202B) including a heat dissipation substrate for power semiconductors according to an additional embodiment of the third embodiment.

The additional embodiment illustrated in FIG. 6B may adopt the technical features of the third embodiment (202) illustrated in FIG. 6A, and the features of the additional embodiment (202B) will be described below.

The additional embodiment illustrated in FIG. 6B may adopt the technical features of the power semiconductor module (202) of the third embodiment illustrated in FIG. 6A, and the features of the power semiconductor module (202B) of the additional embodiment will be described below.

Referring to FIG. 6B, a fourth filler (244) may be disposed within an insulating substrate (210), and the fourth filler (244) may include a fourth-first filler (244a) and a fourth-second filler (244b). For example, the fourth-first filler (244a) may be disposed on a lower surface of the first metal plate (221). In addition, the fourth-second filler (244b) may be disposed on an upper surface of the second metal plate (222). The above fourth-first filler (244a) may have a shape that is convex downward, and the above fourth-second filler (244b) may have a shape that is convex upward.

In an additional embodiment, at least one of the fourth-first filler (244a) or the fourth-second filler (244b) may be disposed with a length that is at least 1/2 of the thickness of the insulating substrate (210). Accordingly, the heat dissipation efficiency can be improved as the fourth-first filler (244a) or the fourth-second filler (244b) is disposed long in the vertical direction.

In addition, in an additional embodiment, the fourth-first filler (244a) and the fourth-second filler (244b) may be disposed to be staggered in the vertical direction. And the fourth-first filler (244a) and the fourth-second filler (244b) may be disposed to be spaced apart and overlapped in the horizontal direction.

For example, the fourth-second filler (244b) may be disposed between the respective spacing spaces of the plurality of fourth-first fillers (244a).

In addition, the fourth-first filler (244a) may be disposed between the respective spacing spaces of the plurality of fourth-second fillers (244b).

Accordingly, according to the power semiconductor module (202B) of the additional embodiment, the plurality of fourth-first fillers (244a) and the plurality of fourth-second fillers (244b) may be disposed alternately in the vertical direction and overlapped in the horizontal direction, so that heat generated from the semiconductor device (230) can be effectively transferred downward, while electrical short circuits between the fourth-first filler (244a) and the fourth-second filler (244b) do not occur.

In addition, according to the power semiconductor module (202B) of the additional embodiment, the horizontal width of the region where the fourth-second filler (244b) is disposed may be larger than the horizontal width of the region where the fourth-first filler (244a) is disposed. In addition, the number of the fourth-second fillers (244b) may be larger than the number of the fourth-first fillers (244a). Accordingly, according to the additional embodiment, by controlling the horizontal width of the fourth-second filler (244b) to be larger than the horizontal width of the fourth-first filler (244a), the heat transferred from the semiconductor device (230) is transferred downward, and thus the heat may be evenly distributed in the downward and horizontal directions as the thermal conductivity increases in the horizontal direction.

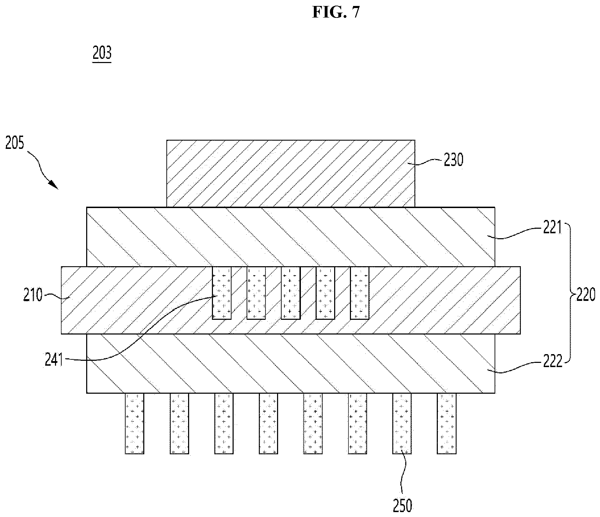

FIG. 7 is a conceptual diagram of a power semiconductor module (203) having a heat dissipation substrate (205) for a power semiconductor module according to the fourth embodiment. The fourth embodiment may adopt the technical features of the first to third embodiments. Referring to FIG. 7, the fourth embodiment may further include a pin-fin structure (250) disposed under the heat dissipation substrate (205). The pin-fin structure (250) may be disposed to contact the lower surface of the second metal plate (222). The pin-fin structure (250) may include a plurality of pins disposed spaced apart from each other. The horizontal width of the plurality of pin-fin structures (250) may be larger than the horizontal width of the plurality of first fillers (241). The pin-fin structure (250) includes a material having excellent thermal conductivity, and may include, for example, Cu, but is not limited thereto.

Accordingly, the embodiment has a technical effect in which heat dissipation performance may be further improved as the pin-fin structure (250) is disposed under the heat dissipation substrate (205).

The heat dissipation substrate for the power semiconductor module according to the embodiment has a technical effect that the heat dissipation performance of the device can be improved by increasing the area through which heat is transferred as the filler (241) is disposed under the first metal plate (221).

For example, in the embodiment, the first metal plate (221) may be disposed under the semiconductor device (230), and the filler (241) may be disposed on the lower surface of the first metal plate (221), so that the area through which heat is transferred increases and the heat dissipation performance can be improved.

In addition, in the embodiment, the heat transfer path can be shortened within the insulating substrate (210), so that the heat dissipation performance can be improved.

For example, in the embodiment, the heat transfer path can be shortened as the filler with excellent thermal conductivity is disposed within the insulating substrate (210), so that heat is transferred through the filler, so that the heat transfer path can be shortened and the heat dissipation performance can be improved.

In addition, the embodiment has a technical effect that may prevent the metal plate (220) and the insulating substrate (210) from being separated and improve reliability.

For example, the embodiment may prevent the metal plate (220) and the insulating substrate (210) from being separated and improve reliability by increasing the bonding force due to an increase in the bonding area between the ceramic of the insulating substrate (210) and the copper (Cu) of the filler (241).

In addition, the embodiment may effectively disperse external stress and improve reliability.

For example, the embodiment may prevent the metal plate (220) and the insulating substrate (210) from being separated and improve reliability by increasing the bonding force due to an increase in the bonding area between the ceramic of the insulating substrate (210) and the copper (Cu) of the filler (241).

In addition, the embodiment has a technical effect of uniformly filling the via formed in the insulating substrate (210) by repeatedly filling and heat-treating copper in the via of the insulating substrate (210) to form a filler, thereby suppressing the occurrence of voids and improving heat dissipation performance.

In addition, the embodiment has a technical effect of evenly distributing heat.

For example, the embodiment may evenly distribute heat by forming the horizontal width of the third-second filler (243b) larger than the horizontal width of the third-first filler (243a) as the heat transferred from the semiconductor device (230) increases in the horizontal direction as it is transferred downward.

Although the above has been described with reference to the embodiments of the present invention, those skilled in the art will easily understand that the present invention may be variously modified and changed within the scope of the spirit and scope of the present invention described in the following patent claims.

### [Reference signs]

200, 201, 202. 203: power semiconductor module 205: heat dissipation substrate
210: insulating substrate 220: metal plate 221: first metal plate 222: second metal plate
230: semiconductor device 241: first filler 242: second filler 243: third filler
243a; third-first filler 243b: third-second filler 250: pin-fin structure

## Claims

1. A heat dissipation substrate for a power semiconductor module, comprising:
an insulating substrate;
a first metal plate disposed on the insulating substrate;
a second metal plate disposed under the insulating substrate; and
a filler disposed within the insulating substrate,
wherein the filler is disposed on a lower surface of the first metal plate.

2. The heat dissipation substrate according to claim 1, wherein the filler comprises a plurality of fillers disposed spaced apart from each other.

3. The heat dissipation substrate according to any one of the preceding claims, wherein the filler is disposed to extend downward.

4. The heat dissipation substrate according to any one of the preceding claims, further comprising a bonding metal layer and a diffusion metal layer between the first metal plate and the insulating substrate, and
wherein the first metal plate and the filler are in contact with each other.

5. The heat dissipation substrate according to any one of the preceding claims, wherein the filler comprises a cylindrical shape.

6. The heat dissipation substrate according to any one of the preceding claims 1 to 4, wherein the filler comprises a hemispherical shape.

7. The heat dissipation substrate according to any one of the preceding claims, further comprising a pin-fin structure disposed on a lower surface of the second metal plate.

8. The heat dissipation substrate according to any one of the preceding claims, wherein the filler is spaced apart from the upper surface of the second metal plate.

9. The heat dissipation substrate according to any one of the preceding claims, wherein the filler comprises:
a first filler in contact with the lower surface of the first metal plate; and
a second filler in contact with an upper surface of the second metal plate.

10. The heat dissipation substrate according to claim 9, wherein a horizontal width of each the plurality of second fillers is larger than that of each the plurality of first fillers, and wherein the first filler is spaced apart from the second metal plate.

11. The heat dissipation substrate according to claim 9 or 10, wherein the second filler is spaced apart from the first filler.

12. The heat dissipation substrate according to claim 9, 10 or 11, wherein the second filler is alternately disposed on surfaces facing the first filler.

13. The heat dissipation substrate according to claim 9, 10, 11 or 12, further comprising a pin-fin structure disposed on a lower surface of the second metal plate.

14. The heat dissipation substrate according to claim 9, 10, 11, 12 or 13, wherein a vertical length of each the first filler or the second filler is at least 1/2 of a thickness of the insulating substrate.

15. The heat dissipation substrate according to any one of claims 9 to 14, wherein the first filler and the second filler are disposed alternately in a vertical direction, and
wherein a horizontal width of a region where the second filler is disposed is larger than a horizontal width of a region where the first filler is disposed.
